# EUROPÄISCHE PATENTANMELDUNG

(11) **EP 0 866 564 A2**
(43) Veröffentlichungstag der Anmeldung: **23.09.1998**
(21) Anmeldenummer: 98103676.7
(22) Anmeldetag: 03.03.1998
(51) Int. Cl.: H03M 5/12

(54) **Verfahren zur Decodierung eines einer seriellen Datenbitfolge entprechenden Datensignals**

(30) Priorität: 19.03.1997 DE 19711432
(71) Anmelder: TEMIC TELEFUNKEN microelectronic GmbH, 74072 Heilbronn (DE)
(72) Erfinder: Jochum, Herbert, 88263 Horgenzell (DE); Wilhelm, Günter, 88677 Markdorf (DE)
(74) Vertreter: Maute, Hans-Jürgen, Dipl.-Ing.

(57) **Zusammenfassung**

Beschrieben wird ein Verfahren zur Decodierung eines nach dem sogenannten Manchester-Verfahren codierten Datensignals, welches in einem Zeitraster mit einer vorgegebenen Rasterbreite Signalflanken aufweist, deren Vorzeichen den Datenbits einer seriellen Datenbitfolge entsprechenden. Zur Decodierung des Datensignals wird dieses in aufeinanderfolgende Teilsignale unterteilt, die entweder durch aufeinanderfolgende steigende oder durch aufeinanderfolgende fallende Signalflanken begrenzt sind. Diesen Teilsignalen wird jeweils ein Teilcode zugeordnet, die entsprechend der Reihenfolge der Teilsignale zur decodierten Datenbitfolge aneinandergereiht werden. Die Teilcodes werden dabei jeweils nach Maßgabe der Breite der Teilsignale, denen sie zugeordnet sind, und nach Maßgabe des dem jeweiligen Teilcode vorangehenden Teilcodes generiert.

## Beschreibung

Die Erfindung betrifft ein Verfahren zur Decodierung eines Datensignals gemäß dem Oberbegriff des Patentanspruchs 1.

Derartige Datensignale werden üblicherweise in der Übertragungstechnik eingesetzt, um serielle Datenbitfolgen mit einer bestimmten Bitrate, d. h. mit einer bestimmten Anzahl von Bits je Zeiteinheit, beispielsweise über eine Funkstrecke, von einer Sendeeinheit zu einer Empfangseinheit zu übertragen. In der Druckschrift 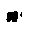 Automotive Safety and Convenience Data Book 1995", der Firma TEMIC TELEFUNKEN microelectronic GmbH wird auf den Seiten 77 - 78 ein als Manchester-Modulation bezeichnetes Codierungsverfahren beschrieben, bei dem aus einer seriellen Datenbitfolge ein Datensignal erzeugt wird, welches in einem Zeitraster mit einer der Bitrate entsprechenden Rasterbreite positive oder negative, d. h. steigende oder fallende Signalflanken aufweist. Das Vorzeichen dieser Signalflanken entspricht dabei jeweils durch dem zu übertragenden Datenbit der Datenbitfolge. Das Daten-signal weist des weiteren jeweils zwischen zwei im Zeitraster aufeinanderfolgenden Signalflanken gleicher Steigungsrichtung eine Signalflanke mit entgegengesetzter Steigungsrichtung auf, welche jedoch keine Bitinformation enthält. Bei der Decodierung des Datensignals werden daher üblicherweise nur die im Zeitraster liegenden Signalflanken des Datensignals ausgewertet. Zur Identifizierung dieser Signalflanken wird ein Taktsignal mit einer der Bitrate entsprechenden Frequenz erzeugt und zum Datensignal synchronisiert.

Der Erfindung liegt die Aufgabe zugrunde, ein Verfahren gemäß dem Oberbegriff des Patentanspruchs 1 anzugeben, das auf einfache Weise ohne ein zum Datensignal synchronisiertes Taktsignal durchgeführt werden kann.

Die Aufgabe wird erfindungsgemäß durch die kennzeichnenden Merkmale des Patentanspruchs 1 gelöst. Vorteilhafte Weiterbildungen und Ausgestaltungen ergeben sich aus den Unteransprüchen.

Der Erfindung liegt die Erkenntnis zugrunde, das die Abstände zwischen den Signalflanken des Datensignals von den Datenbits der Datenbitfolge abhängig sind und daß es daher möglich ist, die Decodierung des Datensignals auf eine Messung der zeitlichen Abstände zwischen Signalflanken gleicher Steigungsrichtung zurückzuführen. Erfindungsgemäß wird das Datensignal in aufeinanderfolgende Teilsignale unterteilt, die durch aufeinanderfolgende Signalflanken gleichen Vorzeichens begrenzt werden, d. h. die Teilsignale sind alle entweder durch jeweils zwei aufeinanderfolgende steigende Signalflanken oder durch jeweils zwei aufeinanderfolgende fallende Signalflanken begrenzt. Den Teilsignalen wird jeweils ein Teilcode zugeordnet, welche entsprechend der Reihenfolge der Teilsignale zu der das Datensignal darstellenden decodierten Datenbitfolge aneinandergereiht werden. Die Bitmuster der Teilcodes werden dabei jeweils nach Maßgabe der Breite desjenigen Teilsignals, dem sie zugeordnet sind, d. h. nach Maßgabe des zeitlichen Abstandes zwischen den dieses Teilsignal begrenzenden Signalflanken des Datensignals generiert. Sie werden ferner auch nach Maßgabe des dem jeweils vorangehenden Teilsignal zugeordneten Teilcodes, vorzugsweise nach Maßgabe eines Vorgängerbits generiert, wobei vorteilhafterweise beim ersten Teilcode ein vordefiniertes Startbit und bei jedem der folgenden Teilcodes das letzte Bit des jeweils vorangehenden Teilcodes als Vorgängerbit verwendet Wird.

Vorzugsweise wird zur Erzeugung eines Teilcodes geprüft, ob die Breite des entsprechenden Teilsignals, d. h. desjenigen Teilsignals, dem der Teilcode zugeordnet ist, etwa gleich dem einfachen Wert, dem 1,5fachen Wert oder dem doppelten Wert der Rasterbreite ist. Das Bitmuster des Teilcodes wird dann derart gewählt, daß es bei einer der Rasterbreite gleichen Breite des entsprechenden Teilsignals ein dem Vorgängerbit gleiches Bit aufweist, bei einer dem doppelten Wert der Rasterbreite gleichen Breite des entsprechenden Teilsignals eine Folge aus einem dem negierten Vorgängerbit gleichen Bit und einem dem Vorgängerbit gleichen Bit ist und bei einer etwa dem 1,5fachen Wert der Rasterbreite gleichen Breite des entsprechenden Teilsignals ein dem negierten Vorgängerbit gleiches Bit und ggf. ein diesem Bit vorangesetztes Zusatzbit aufweist, wobei das Zusatzbit nur bei einem bestimmten Bitwert des Vorgängerbits, d. h. entweder bei einem dem Bitwert 1 gleichen Vorzeichenbit oder bei einem dem Bitwert 0 gleichen Vorzeichenbit, vorhanden ist.

In einer vorteilhaften Ausgestaltung des Verfahrens wird das Zusatzbit derart vordefiniert, daß es dann, wenn die die Teilsignale begrenzenden Signalflanken das dem Bitwert 0 entsprechende Vorzeichen aufweisen, gleich dem Bitwert 1 ist und dann, wenn die die Teilsignale begrenzenden Signalflanken das dem Bitwert 1 entsprechende Vorzeichen aufweisen, gleich dem Bitwert 0 ist. Das Startbit wird in diesem Fall vorteilhafterweise als derjenige Bitwert definiert, der einer positiven Signalflanke des Datensignals entspricht.

In einer weiteren Ausgestaltung des Verfahrens wird das Zusatzbit dann, wenn die die Teilsignale begrenzenden Signalflanken das dem Bitwert 0 entsprechende Vorzeichen aufweisen, als 0 definiert und dann, wenn die die Teilsignale begrenzenden Signalflanken das dem Bitwert 1 entsprechende Vorzeichen aufweisen, als 1 definiert. Das Startbit wird in diesem Fall vorteilhafterweise als derjenige Bitwert definiert, der einer negativen Signalflanke des Datensignals entspricht. Als decodierte Datenbitfolge erhält man in diesem Fall eine Folge von Datenbits, die bzgl. den Datenbits der dem Datensignal entsprechenden seriellen Datenbitfolge negiert sind.

Der wesentliche Vorteil des erfindungsgemäßen Verfahrens besteht darin, daß kein zum Datensignal synchronisiertes Taktsignal erzeugt werden muß. Eine Schaltungsanordnung zur Durchführung des Verfahrens benötigt daher keine Mittel zur Erzeugung eines derartigen Taktsignals und läßt sich somit mit geringem Schaltungsaufwand realisieren. Außerdem werden mit dem Verfahren Störungen, d. h. Signalflanken, deren Abstand zu der jeweils vorherigen Signalflanke des Datensignals nicht gleich der Rasterbreite, dem 1,5fachen Wert der Rasterbreite oder dem doppelten Wert der Rasterbreite ist, erkannt, so daß Übertragungsfehler vermieden werden.

Die Erfindung wird nachfolgend anhand eines Beispiels unter Bezugnahme auf die Figuren näher beschrieben. Es zeigen:
- Figur 1a:: schematische Darstellung der Verfahrensschritte zur Decodierung eines Datensignals durch Auswertung des Abstandes zwischen Signalflanken mit dem Bitwert 0 entsprechender Steigungsrichtung,
- Figur 1b:: eine erste Wertetafel mit verschiedenen Bitmustern,
- Figur 1c:: eine zweite Wertetafel mit verschiedenen Bitmustern,
- Figur 2a:: schematische Darstellung der Verfahrensschritte zur Decodierung des Datensignals aus Figur 1a durch Auswertung des Abstandes zwischen Signalflanken mit dem Bitwert 1 entsprechender Steigungsrichtung,
- Figur 2b:: eine dritte Wertetafel mit verschiedenen Bitmustern,
- Figur 2c:: eine vierte Wertetafel mit verschiedenen Bitmustern.

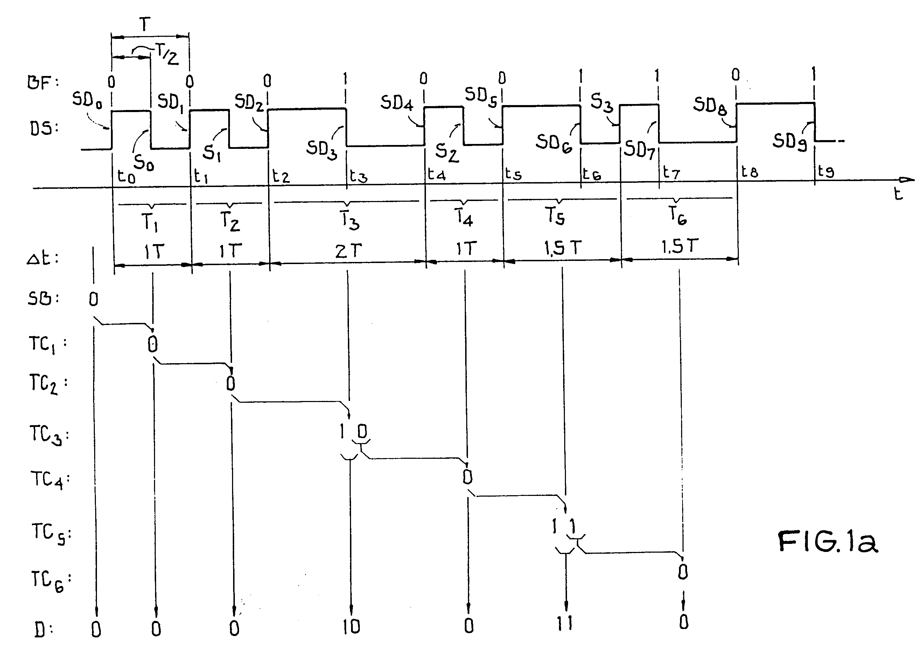

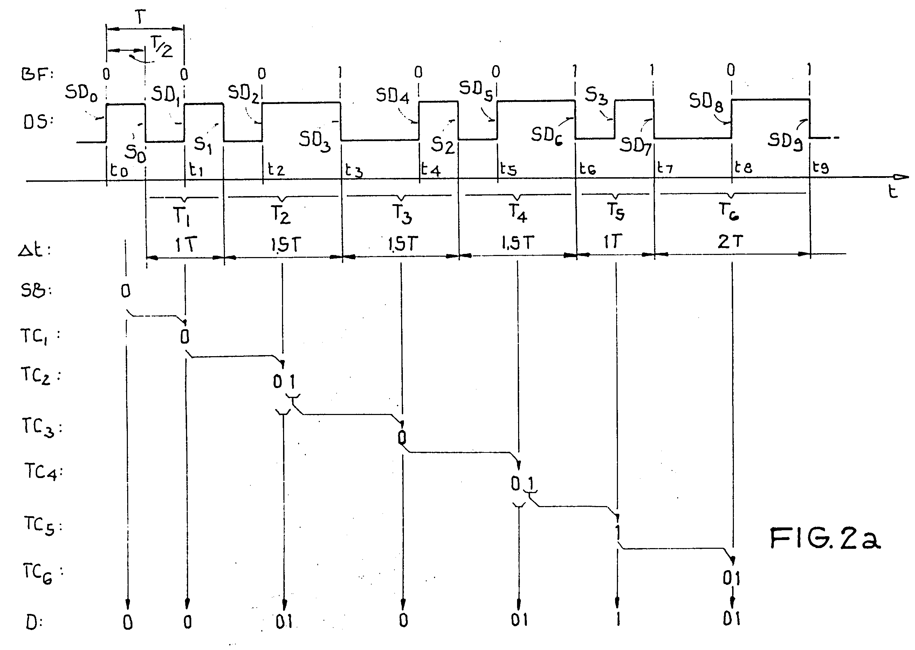

Die serielle Datenbitfolge BF = 0001001101 aus Figur 1a soll mit einer konstanten Datenrate, beispielsweise über eine Funkstrecke, von einer Sendeeinheit zu einer Empfangseinheit übertragen werden. Das heißt, die einzelnen Datenbits der Datenbitfolge BF werden nacheinander zu den im Zeitraster mit der Rasterbreite T liegenden Zeitpunkten t₀ ... t₉ von der Sendeeinheit ausgesendet. Die führenden Nullen und die darauffolgende 1 stellen eine Startbitfolge dar, mit der die Empfangseinheit zum Empfang aktiviert wird. In der Empfangseinheit werden nur die auf die Startbitfolge folgenden, d. h. nur die auf den ersten Bitwertwechsel folgenden, Datenbits 001101 als Nutzdaten interpretiert.

Die Datenbitfolge BF wird als sogenanntes manchester-codiertes Datensignal DS übertragen, welches zu den Zeitpunkten t₀ ... t₉ Signalflanken SD₀ ... SD₉ aufweist, deren Vorzeichen, d. h. Steigungsrichtungen, durch die zu diesen Zeitpunkten t₀ ... t₉ gültigen Bits der Datenbitfolge BF festgelegt werden. Im vorliegenden Beispiel entspricht eine positive, d. h. steigende Signalflanke dem Bitwert 0 und eine negative, d. h. fallende Signalflanke dem Bitwert 1. Der Bitwert 0 wird demnach durch einen Low-Pegel gefolgt von einem High-Pegel und der Bitwert 1 durch einen High-Pegel gefolgt von einem Low-Pegel codiert, wobei die Breite dieser Low- und High-Pegel jeweils gleich der halben Rasterbreite T/2 ist. Denkbar ist jedoch auch eine Codierung, bei der der Bitwert 1 einer positiven und der Bitwert 0 einer negativen Signalflanke entspricht. In der Mitte zwischen den im Zeitraster t₀ ... t₉ liegenden Signalflanken SD₀ ... SD₉ können weitere Signalflanken auftreten, die keine Bitinformation enthalten. Im vorliegenden Beispiel sind dieses die zwischen den Zeitpunkten t₀ und t₁ bzw. t₁ und t₂ bzw. t₄ und t₅ bzw. t₆ und t₇ liegenden Signalflanken S₀ ... S₃. Die Teilsignale T₁ ... T₆ stellen aufeinanderfolgende Teilbereiche des Datensignal DS dar, die durch diejenigen Signalflanken SD₀, SD₁, SD₂, SD₄, SD₅, S₃, SD₈ des Datensignals DS begrenzt werden, die dem Bitwert 0 entsprechende Vorzeichen - im vorliegenden Beispiel sind das positive Vorzeichen - aufweisen. Die Breiten Δt der Teilsignale T₁ ... T₆, d. h. die zeitlichen Abstände Δt zwischen den die Teilsignale T₁ ... T₆ begrenzenden Signalflanken SD₀, SD₁, SD₂, SD₄, SD₅, S₃, SD₈, können gleich der Rasterbreite T, gleich dem 1,5fachen Wert 1,5T der Rasterbreite T oder gleich dem doppelten Wert 2T der Rasterbreite T sein.

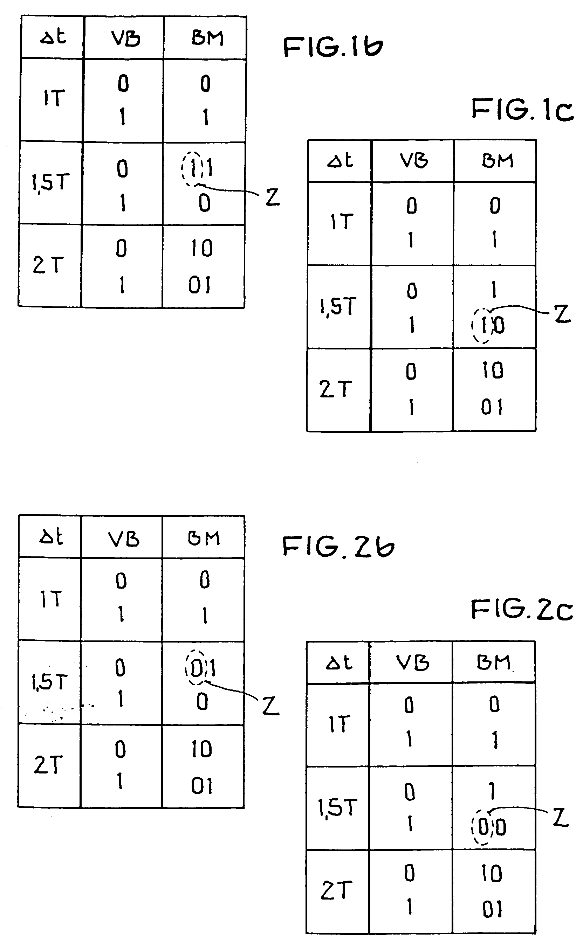

Das Datensignals DS wird sukzessiv decodiert, indem nacheinander die die Teilsignale T₁ ... T₆ begrenzenden Signalflanken SD₀, SD₁, SD₂, SD₄, SD₅, S₃, SD₈ detektiert werden, die Breiten Δt der Teilsignale T₁ ... T₆ gemessen werden, den Teilsignalen T₁ ... T₆ jeweils ein Teilcode TC₁ ... TC₆ zugeordnet wird und die Teilcodes TC₁ ... TC₆ entsprechend der Reihenfolge der Teilsignale T₁ ... T6, denen sie zugeordnet sind, zur decodierten Datenbitfolge D aneinandergereiht werden, wobei der erste Teilcode TC₁ an ein das erste Bit der decodierten Datenbitfolge D darstellendes Startbit SB, welches im vorliegenden Beispiel als 0 vordefiniert wurde, angefügt wird. Die Bitmuster der Teilcodes TC₁ ... TC₆ werden dabei jeweils nach Maßgabe der Breiten Δt der Teilsignale T₁ ... T₆, denen sie zugeordnet sind, und nach Maßgabe des dem jeweiligen Teilcode TC₁ ... TC₆ in der decodierten Datenbitfolge D unmittelbar vorangehenden Vorgängerbits VB - das ist das letzte Bit des jeweils vorherigen Teilcodes, bzw. im Falle des ersten Teilcodes TC₁ das Startbit SB - aus der in Figur 1b gezeigten Tabelle ausgewählt.

Diese Tabelle weist eine Spalte für die Breite Δt, eine Spalte für das Vorgängerbit VB und eine Spalte für die wählbaren Bitmuster BM auf. Gemäß der Tabelle wird für einen Teilcode TC₁ ... TC₆ bei einer Breite Δt = T und einem vorgängerbit VB = 0 der Bitwert 0 als Bitmuster BM gewählt, bei einer Brei-te Δt = T und einem Vorgängerbit VB = 1 der Bitwert 1 als Bitmuster BM gewählt, bei einer Breite Δt = 1,5T und einem Vorgängerbit VB = 0 die Bitwertfolge 11 als Bitmuster BM gewählt, bei einer Breite Δt = 1,5T und einem Vorgängerbit VB = 1 der Bitwert 0 als Bitmuster BM gewählt, bei einer Breite Δt = 2T und einem Vorgängerbit VB = 0 die Bitwertfolge 10 als Bitmuster BM gewählt und bei einer Breite Δt = 2T und einem Vorgängerbit VB = 1 die Bitwertfolge 01 als Bitmuster BM gewählt.

Die Bitmuster BM können jedoch auch gemäß der Tabelle aus Figur 1c gewählt werden. Diese Tabelle unterscheidet sich von der Tabelle aus Figur 1b lediglich in den Bitmustern BM, die dem 1,5fachen Wert 1,5T der Rasterbreite T entsprechen. So wird bei einer Breite Δt = 1,5T und einem Vorgängerbit VB = 0 der Bitwert 1 als Bitmuster BM gewählt und bei einer Breite Δt = 1,5T und einem Vorgängerbit VB = 1 die Bitwertfolge 10 als Bitmuster BM gewählt, wobei die führende 1 das Zusatzbit Z darstellt.

Das Datensignal DS läßt sich auch decodieren, indem, wie in Figur 2a gezeigt, das Datensignal DS in Teilsignale T₁ ... T₆ unterteilt wird, die durch Signalflanken mit dem Bitwert 1 entsprechenden Vorzeichen begrenzt werden; im vorliegenden Beispiel sind das die negativen Signalflanken S₀, S₁, SD₃, S₂, SD₆, SD₇ und SD₉. Diesen Teilsignalen T₁ ... T₆ wird in der gleichen Art wie in Figur 1a jeweils ein Teilcode TC₁ ... TC₆ zugeordnet, die aneinandergereiht das decodierte Datensignal D ergeben. Die Bitmuster BM der Teilcodes TC₁ ... TC₆ werden jedoch gemäß der in Figur 2b gezeigten Tabelle gewählt. Diese unterscheidet sich von der Tabelle aus Figur 1b in einem einzigen Wert. So wird bei einer dem 1,5fachen Wert 1,5T der Rasterbreite T gleichen Breite Δt und einem dem Bitwert 0 gleichen Vorgängerbit VB nicht die Bitwertfolge 11 sondern die Bitwertfolge 01 als Bitmuster BM gewählt, d. h. das Zusatzbit Z wird gleich dem Bitwert 0 gewählt.

Die Bitmuster BM können jedoch auch gemäß der Tabelle aus Figur 2c gewählt werden. Diese unterscheidet sich von der Tabelle aus Figur 1c lediglich dadurch, daß bei einer Breite Δt = 1,5T und einem Vorgängerbit VB = 1 die Bitwertfolge 00 als Bitmuster BM gewählt wird, wobei die führende Null das Zusatzbit Z darstellt.

In den Beispielen aus den Figuren 1a und 2a wird der Bitwert 0 als Startbit SB verwendet. Das Startbit SB kann jedoch auch als 1 vordefiniert werden. In diesem Fall werden die Bitmuster BM beim verfahren gemäß Figur 1a statt aus den in Figur 1b oder 1c gezeigten Tabellen aus einer der in den Figuren 2b oder 2c gezeigten Tabelle gewählt und beim Verfahren gemäß Figur 2a statt aus den in Figur 2b oder 2c gezeigten Tabellen aus einer der in den Figuren 1b oder 1c gezeigten Tabelle gewählt. Die decodierte Datenbitfolge D, die man dann erhält, ist bzgl. der seriellen Datenbitfolge BF negiert.

Mit dem Verfahren lassen sich auch Datensignale DS, bei denen der Bitwert 0 einer negativen Signalflanke entspricht, decodieren. In diesem Fall wird, falls die decodierte Datenbitfolge D gleich der Bitfolge BF sein soll, der Bitwert 1 als Startbit SB verwendet und, falls die decodierte Datenbitfolge D gleich der negierten Datenbitfolge BF sein soll, der Bitwert 0 als Startbit SB verwendet. Dabei werden die Bitmuster BM dann, wenn die die Teilsignale T₁ ... T₆ begrenzenden Signalflanken negatives Vorzeichen aufweisen und das Startbit SB als 1 vordefiniert wird oder dann, wenn die die Teilsignale T₁ ... T₆ begrenzenden Signalflanken positive Vorzeichen aufweisen und das Startbit SB als 0 vordefiniert wird, aus einer der in den Figuren 1b oder 1c gezeigten Tabelle gewählt und dann, wenn die die Teilsignale T₁ ... T₆ begrenzenden Signalflanken negatives Vorzeichen aufweisen und das Startbit SB als 0 vordefiniert wird oder dann, wenn die die Teilsignale T₁ ... T₆ begrenzenden Signalflanken positive Vorzeichen aufweisen und das Startbit SB als 1 vordefiniert wird, aus einer der in den Figuren 2b oder 2c gezeigten Tabelle gewählt.

## Patentansprüche

1. Verfahren zur Decodierung eines einer seriellen Datenbitfolge (BF) entsprechenden Datensignals (DS), welches in einem Zeitraster (t₀ ... t₁) mit einer vorgegebenen Rasterbreite (T) Signalflanken (SD₀ ... SD₉) aufweist, deren Vorzeichen jeweils einem Datenbit der Datenbitfolge (BF) entsprechen, dadurch gekennzeichnet,
- daß das Datensignal (DS) in aufeinanderfolgende Teilsignale (T₁ ... T₆) unterteilt wird, die jeweils entweder durch aufeinanderfolgende positive Signalflanken (SD₀, SD₁, SD₂, SD₄, SD₅, S₃, SD₈) oder durch aufeinanderfolgende negative Signalflanken (S₀, S₁, SD₃, S₂, SD₆, SD₇, SD₉) begrenzt sind,
- daß den Teilsignalen (T₁ ... T₆) jeweils ein Teilcode (TC₁ ... TC₆) mit einem Bitmuster (BM) aus mindestens einem Bit zugeordnet wird, wobei der einem Teilsignal (T₁ ... T₆) zugeordnete Teilcode (TC₁ ... TC₆) nach Maßgabe der Breite (Δt) dieses Teilsignals (T₁ ... T₆) und nach Maßgabe des dem vorangehenden Teilsignal (T₁ ... T₅) zugeordneten Teil-codes (TC₁ ... TC₅) generiert wird
- und daß die Teilcodes (TC₁ ... TC₆) entsprechend der Reihenfolge der Teilsignale (T₁ ... T₆) zur decodierten Datenbitfolge (D) aneinandergereiht werden.

2. Verfahren nach Anspruch 1, dadurch gekennzeichnet, daß die Teilcodes (TC₁ ... TC₆) jeweils nach Maßgabe eines Vorgängerbits (VB) generiert werden, wobei das Vorgängerbit (VB) eines Teilcodes (TC₂ ... TC₆) durch den diesem Teilcode (TC₂ ... TC₆ ) vorangehenden Teilcode (TC₁ ... TC₅) festgelegt wird.

3. Verfahren nach Anspruch 2, dadurch gekennzeichnet, daß beim ersten Teilcode (TC₁ ) ein vordefiniertes Startbit (SB) und bei den folgenden Teilcodes (TC₂ ... TC₆) jeweils das letzte Bit des dem jeweiligen Teilcode (TC₂ ... TC₆) vorangehenden Teilcodes (TC₁ ... TC₅) als Vorgängerbit (VB) verwendet wird.

4. Verfahren nach Anspruch 3, dadurch gekennzeichnet, daß das Bitmuster (BM) von jedem Teilcode (TC₁ bzw. ... TC₆) derart gewählt wird, daß es
- bei einer der Rasterbreite (T) gleichen Breite (Δt) des entsprechenden Teilsignals (T₁ bzw. ... T₆ ) ein dem Vorgängerbit (VB) gleiches Bit aufweist,
- bei einer etwa dem 1,5fachen Wert (1,5T) der Rasterbreite (T) gleichen Breite (Δt) des entsprechenden Teilsignals (T₁ bzw. ... T₆) ein dem negierten vorgängerbit gleiches Bit aufweist, dem bei einem bestimmten Bitwert des Vorgängerbits (VB) ein Zusatzbit (Z) vorangesetzt ist,
- bei einer dem doppelten Wert (2T) der Rasterbreite (T) gleichen Breite (Δt) des entsprechenden Teilsignals (T₁ bzw. ... T₆) eine Folge aus einem dem negierten Vorgängerbit gleichen Bit und einem dem Vorgängerbit (VB) gleichen Bit aufweist.

5. Verfahren nach Anspruch 4, dadurch gekennzeichnet, daß das Zusatzbit (Z) bei dem Bitwert 0 entsprechenden Vorzeichen der die Teilsignale (T₁ ... T₆) begrenzenden Signalflanken (SD₀, SD₁, SD₂, SD₄, SD₅, S₃, SD₈) als 1 definiert wird und bei dem Bitwert 1 entsprechenden Vorzeichen der die Teilsignale (T₁ ... T₆) begrenzenden Signalflanken (S₀, S₁, SD₃, S₂, SD₆, SD₇, SD₉) als 0 definiert wird.

6. Verfahren nach Anspruch 5, dadurch gekennzeichnet, daß der einer positiven Signalflanke (SD₀, SD₁, SD₂, SD₄, SD₅, S₃, SD₈) des Datensignals (DS) entsprechende Bitwert als Startbit (SB) definiert wird.

7. Verfahren nach Anspruch 4, dadurch gekennzeichnet, daß das Zusatzbit (Z) bei dem Bitwert 0 entsprechenden Vorzeichen der die Teilsignale (T₁ ... T₆) begrenzenden Signalflanken (SD₀, SD₁, SD₂, SD₄, SD₅, S₃, SD₈) als 0 definiert wird und bei dem Bitwert 1 entsprechenden Vorzeichen der die Teilsignale (T₁ ... T₆₎ begrenzenden Signalflanken (S₀, S₁, SD₃, S₂, SD₆, SD₇, SD₉) als 1 definiert wird.

8. Verfahren nach Anspruch 7, dadurch gekennzeichnet, daß der einer negativen Signalflanke (S₀, S₁, SD₃, S₂, SD₆, SD₇, SD₉) des Datensignals (DS) entsprechende Bitwert als Startbit (SB) definiert wird.
